(19) Europäisches Patentamt
European Patent Office
Office européen des brevets

(11) Numéro de publication: **0 250 305**
**B1**

(12) **FASCICULE DE BREVET EUROPEEN**

(45) Date de publication du fascicule du brevet: **23.01.91**

(51) Int. Cl.$^5$: **C 30 B 15/00,** C 30 B 29/22

(21) Numéro de dépôt: **87401329.5**

(22) Date de dépôt: **12.06.87**

(54) **Aluminates mixtes de lanthanide-magnésium, lasers utilisant des monocristaux de ces aluminates.**

(30) Priorité: **16.06.86 FR 8608660**

(43) Date de publication de la demande:
**23.12.87 Bulletin 87/52**

(45) Mention de la délivrance du brevet:
**23.01.91 Bulletin 91/04**

(84) Etats contractants désignés:
**DE GB**

(56) Documents cités:
**EP-A- 227 499**
**EP-A-0 043 776**
**FR-A-2 588 848**

**JOURNAL OF APPLIED PHYSICS, vol. 52, no. 11, novembre 1981, pages 6864-6869, American Institute of Physics, New York, US; A. KAHN et al.: "Preparation, structure, optical, and magnetic properties of lanthanide aluminate single crystals (LnMAl11O19)**

(73) Titulaire: **COMMISSARIAT A L'ENERGIE ATOMIQUE Etablissement de Caractère Scientifique Technique et Industriel**
**31/33, rue de la Fédération**
**F-75015 Paris (FR)**
(73) Titulaire: **CENTRE NATIONAL DE LA RECHERCHE SCIENTIFIQUE (CNRS)**
**15, Quai Anatole France**
**F-75007 Paris (FR)**

(72) Inventeur: **Aubert, Jean-Jacques**
**6 Résidence Beauséjour**
**F-38120 Le Fontanil-Cornillon (FR)**
Inventeur: **Lejus, Anne-Marie**
**70 Avenue A. Briand**
**F-92120 Montrouge (FR)**
Inventeur: **Viana, Bruno**
**51, rue des Verdun**
**F-94520 Mandres-Les-Roses (FR)**
Inventeur: **Vivien, Daniel**
**6 bis, rue de Kraustadt**
**F-92380 Garches (FR)**

(74) Mandataire: **Mongrédien, André et al**
**c/o BREVATOME 25, rue de Ponthieu**
**F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**EP 0 250 305 B1**

Courier Press, Leamington Spa, England.

## Description

La présente invention a pour objet des aluminates mixtes de lanthanide-magnésium obtenus sous forme de monocristaux et trouvant des applications particulières dans le domaine des microlasers pour l'optique intégrée, les télécommunications par fibres optiques ou la médecine (microchirurgie, traitement de la peau), dans le domaine des lasers de puissance émettant dans l'infrarouge ou le visible avec un certain degré d'accordabilité et des lasers de puissance accordables dans le visible permettant notamment d'effecteur des traitements de matériaux (soudure, perçage, marquage, traitment de surface), des réactions photochimiques, la fusion thermonucléaire contrôlée ou la polarisation des atomes d'un gaz tel que l'hélium.

Certains lasers selon l'invention émettent aux longueurs d'onde de 1054 nm, 1082 nm, 1320 nm avec un certain degré d'accordabilité, d'autres lasers émettent dans la gamme de 1,5 à 3 micrométres et d'autres lasers encore émettent avec accordabilité entre 680 et 800 nm.

Comme aluminates mixtes de lanthanide-magnésium, on connaît en particulier des aluminates de lanthane-néodymemagnésium, appelés LNA, de formule chimique $La_{1-x}Nd_xMgAl_{11}O_{19}$ avec $0 < x \leq 1$ et de préférence de formule $La_{0,9}Nd_{0,1}MgAl_{11}O_{19}$. Ces aluminates mixtes ont notamment fait l'objet des brevets FR—A—2 448 134 et EP—A—0 043 776 déposés aux noms des demandeurs.

Ces aluminates mixtes obtenus sous forme monocristalline présentent des propriétés lasers comparables à celles que présente le grenat d'yttrium et d'aluminium dopé au néodyme, connus sous l'abréviation YAG:Nd, et l'ultraphosphate de néodyme ($NdP_5O_{14}$), émettant dans l'infrarouge.

En particulier, le LNA présente des longueurs d'onde d'émission laser particuliérement intéressantes à 1054 et 1082 nm encadrant celle du YAG à 1064 nm. En outre, il présente un autre domaine de longueurs d'onde d'émission autour de 1320 nm, domaine corespondant à la plus faible atténuation par les fibres optiques en silice, ce qui permet ainsi la transmission d'un maximum d'informations avec un minimum de perte.

Les monocristaux de LNA peuvent être obtenus par un grand nombre de méthodes de cristallogénèse utilisant un bain fondu telles que la méthode de Verneuil ou la méthode de Czochralski, afin de présenter l'effet laser.

Toutefois, ces aluminates ne présentent pas de fusion dite congruante, c'est-à-dire que le monocristal ne possède pas le même composition que le bain fondu.

En conséquence, la fabrication de monocristaux de ces aluminates et en particulier par la méthode de Czochralski la plus couramment utilisée, conduit à des cristaux de qualité insuffisante (bulles, défauts) dès qu'il s'agit d'atteindre les grandes dimensions requises par l'industrie des lasers et plus spécialement des lasers de puissance (barreau de 6,35 mm de diamètre et de 100 mm de long).

En outre, les longueurs d'onde d'émission laser du LNA sont en nombre réduit.

Il est connu par ailleurs, des aluminates mixtes de lanthane-néodyme-magnèsium de formule $La_{1-x}Nd_xMg_yAl_{11}O_{18+y}$ dans laquelle x et y représentent des nombres tels des $0 < x \leq 0,2$ et $0 < y < 1$, avec de préférence $0,4 < y < 0,7$. Ces aluminates mixtes ont notamment fait l'objet d'une demande de brevet FR—A—2 588 848 déposée aux noms des demandeurs le 21 octobre 1985 et d'une demand EP—A—0 227 499 opposable selon l'article 54(3) de la CBE.

Ces aluminates mixtes apportent une amélioration par rapport au LNA en ce qui concerne l'élaboration de monocristaux de grandes dimensions. Toutefois, la gamme de longueur d'onde couverte par ces lasers est encore limitée.

L'invention a justement pour objet de nouveaux aluminates mixtes de lanthanide-magnésium réalisés sous forme de monocristaux de grandes dimensions, et par conséquent utilisables dans l'industrie des lasers de puissance, émettant dans une gamme de longueur d'onde allant du jaune à l'infrarouge (3 micromètres).

Selon la caractéristique principale de l'invention, ces aluminates mixtes de lanthanide-magnésium, se caractérisent en ce qu'ils présentent la formule (I) suivante:

$$(La_{1-x}Tr_x)_{1-y-v}Mg_{1-z-t}Al_{11-u+y+2z/3}Cr_uO_{19-t-3v/2}$$

dans laquelle Tr représente a) au moins un corps simple trivalent choisi parmi les lanthanides autres que le lanthane, excepté lorsque u est $\neq 0$, l'yttrium et le scandium, ou b) au moins un couple de lanthanides formé d'un élément bivalent et d'un élément trivalent autre que le lanthane, excepté lorsque u est $\neq 0$, avec conservation de la neutralité électrique par adjonction d'aluminium ou de lacunes d'oxygène, ou toute combinaison de ce(s) corps simple(s) et de ce(s) couple(s); x représente un nombre tel que $0 \leq x < 1$; y et v représentent des nombres tels que $0 \leq y + v \leq 0,4$, z et t représentent des nombres tels que $0 \leq Z + t < 1$ à condition que lorsque $z + t = 0$, $y + v$ soit $\neq 0$ pour Tr représentant un seul lanthanide trivalent; u est un nombre allant de 0 à 2 à condition que lorsque Tr représente $Y^{3+}$ ou $Sc^{3+}$, u soit $\neq 0$, que lorsque $x = 0$, u soit $\neq 0$, que lorsque $u = 0$, x soit $\neq 0$ et que lorsque $y = v = z = u = 0$ et $t \neq 0$, Tr ne représente pas un seul lanthanide trivalent et que lorsque $Tr = Nd^{3+}$, $y - u + 2z/3$ soit $\neq 0$. En outre, ces aluminates mixtes sont monophasés et présentent une structure cristalline du type magnétoplombite, à maille hexagonale.

Ils possèdent notamment des propriétés mécaniques voisines de celles de l'alumine.

Selon l'invention, ces aluminates peuvent être utilisés comme émetteurs lasers dans une grande

gamme de longueurs d'onde, cette dernière dépendant de la nature de Tr et de la présence ou non de chrome. En outre, un grand nombre de ces aluminates présente un fusion dite congruante et les cristaux élaborés par la méthode de Czochralski sont de bonne qualité; il devient alors possible de préparer des monocristaux de grandes dimensions demandés par l'industrie des lasers de puissance.

Par alleurs, ces aluminates mixtes présentent pendant la croissance du monocristal une absence de ségrégation des constituants permettant d'augmenter la vitesse de tirage du monocristal par rapport à celle du LNA. Ceci entraîne de ce fait un gain important sur la durée de préparation des monocristaux ainsi que sur la durée de vie des creusets contenant le bain fondu à partir duquel on effectue le tirage.

Dans la formule (I) ci-dessus, pour $x \neq 0$, Tr est par exemple choisi parmi le néodyme, le praséodyme, l'erbium, l'holmium, le thulium, les couples néodyme-europium divalent, praséodyme-europium divalent et les couples praséodyme-samarium, praséodyme-dysprosium, praséodyme-thulium, A-néodyme, A-praséodyme, A-erbium, A-holmium, A-thulium avec A représentant un élément choisi parmi l'yttrium, le scandium, le lutétium, le cérium et le gadolinium.

De préference Tr est choisi parmi le néodyme, le praséodyme, l'erbium, l'holmium, le thulium, les couples néodyme-europium divalent, praséodyme-europium divalent et les couples cérium-néodyme, cérium-praséodyme, praséodyme-samarium, praséodyme-dysprosium, praséodyme-thulium, cérium-erbium, cérium-holmium.

Lorsque dans la formule (I) x est égale à 0 et par conséquent u non nul, les aluminates mixtes correspondants, réalisés sous forme de monocristaux, peuvent être utilisés comme laser continu ou pulsé émettant dans le visible et le proche infrarouge avec accordabilité entre 680 et 800 nm, l'émission laser étant due au chrome.

Actuellement, seule l'alexandrite dopée au chrome de formule $BeAl_2O_4:CR^{3+}$, émettant entre 680 et 800 nm, présente une réelle importance industrielle pour les laser vibroniques. Les lasers vibroniques sont des lasers accordables dans lesquels les niveaux d'énergie responsables de l'effet laser sont des niveaux vibrationnels excités de l'état électronique fondamental.

Lorsque Tr représente le praséodyme ou un couple D-praséodyme où D represénte un élément choisi parmi l'yttrium, le scandium, le lutétium, le cérium, le samarium, le dysprosium, le thulium à l'état trivalent ou l'europium à l'état divalent avec $x \neq 0$, les aluminates mixtes correspondants selon l'invention, réalisés sous forme monocristalline, peuvent être utilisés comme émetteur laser émettant dans le visible et principalement dans le jaune et dans le rouge.

Ces aluminates dont la luminescence est due au praséodyme sont utilisables en particulier dans les lasers continus ou pulsés de puissance.

Par laser de puissance, il faut comprendre un laser émettant un faisceau lumineux d'au moins plusieurs watts.

Lorsque dans la formule (I) Tr représente le néodyme ou le couple E-néodyme avec E représentant l'yttrium, le scandium, le lutétium, le cérium à l'état d'oxydation III ou l'europium à l'état d'oxydation II, avec $x \neq 0$ les aluminates mixtes correspondant, réalisés sous forme de monocristaux, peuvent être utilisés comme émetteur laser, notamment dans des lasers de puissance, émettant dans l'infrarouge, et en particulier à 1054 nm, 1082 ou 1320 nm comme le LNA. Dans ces aluminates, l'emission laser est due au néodyme.

Lorsque dans la formule (I) Tr représente l'holmium ou un couple G-holmium, avec G représentant l'yttrium, le scandium, le lutétium ou le cérium avec $x \neq 0$, les aluminates mixtes correspondantes, fabriqués sous forme de monocristaux, peuvent être utilisés comme émetteurs lasers et en particulier dans des lasers de puissance émettant dans l'infrarouge et plus spécialement à des longueurs d'onde allant de 1500 à 3000 nm.

Les longueurs d'onde au voisinage de 3000 nm ont l'avantage d'être absorbées par l'eau. En outre, au voisinage de 1,5 micromètre, l'oeil n'est plus sensible à l'émission laser. Il s'ensuit une sécurité pour cet oeil.

D'autres longueurs d'onde peuvent être émises lorsque Tr représente l'erbium ou le thulium pris isolément ou combiné avec le cérium, l'yttrium, le scandium ou le lutétium, ou toute autre terre rare. Avec l'erbium, les émissions laser sont en particulier dans l'infrarouge.

On sait que l'effet laser dépend de certains paramètres et en particulier, de la durée de vie de l'etat excité $E_1$ des ions à l'origine de l'effet laser. Si la durée de vie de cet état excité est suffisamment importante, l'inversion de population, correspondant à un nombre d'ions dans l'état excité supérieure au nombre d'ions dans l'état fondamental, peut avoir lieu.

Les transitions possibles entre le niveau excité $E_1$ et des niveaux d'énergie plus faible pour le néodyme, le prasédoyme, l'holmium, le thulium, l'erbium, et le chrome sont notamment décrites dans un article de revue Phys. Status Sol. (a) 87, 11, (1985) intitulé "Achievements in the Field of Physics and Spectroscopy of Activated Laser Crystals" de A. Kaminskii.

Des études ont montré que plus le composé mixte selon l'invention contenait de lanthane, plus la durée de vie de l'état excité $E_1$ augmentait. En revanche, l'intensité de la fluorescence augmente avec la concentration en ions luminescents. Toutefois, une trop grande quantité d'ions luminescents favorise des interactions entre ces ions, nuisibles à la fluorescence.

Pour réaliser le peuplement de l'état excité $E_1$, on excite les ions luminescents jusqu'à un niveau d'énergie $E_2$ supérieur à l'état excité $E_1$. Le peuplement de l'état $E_2$ est obtenu par absorption de lumière, ou

pompage optique. Le niveau d'énergie $E_2$ étant très instable, les ions luminescents se désexcitent spontanément jusqu'à l'état d'énergie $E_1$.

Etant donné que les pics d'absorption des lanthanides et en particulier du néodyme sont très étroits, la substitution partielle de l'aluminium par du chrome favorise l'absorption de lumière par l'aluminate. En effet, le chrome présente dans le visible des bandes d'absorption larges: une première bande allant de 400 à 500 nm et une seconde bande allant de 600 à 700 nm.

Aprés avoir été porté a l'état excité par absorption de lumière dans l'une ou l'autre de ces bandes spectrales, le chrome transfère son énergie aux ions néodyme permettant ainsi le peuplement du niveau d'énergie $E_1$.

Cette transmission d'énergie est possible car la différence d'énergie entre l'état fondamental et l'état excité des ions chrome est voisine de la différence d'énergie entre l'état fondamental et l'état superexcité $E_2$ des ions néodyme.

Le pompage optique dans les aluminates contenant du praséodyme peut être favorisé en substituant une partie des atomes luminescents par du samarium, du dysprosium, du thulium, du cérium trivalent ou de l'europium divalent. En effet, certains de ces éléments présentent des bandes d'absorption aussi larges que celles du chrome (la largeur des bandes d'absorption de ces lanthanides et du chrome ets liée à la nature de leurs transitions d'un niveau D à un niveau F). En outre, tous ces éléments satisfont à la règle de résonance entre certaines transitions de fluorescence et l'absorption du praséodyme.

Ces éléments (lanthanides ou chrome) sont appelés des sensibilisateurs d'émission lasers alors que les ions luminescents responsables de l'effet lasers sont appelés des activateurs laser.

Le sensibilisateur et l'activateur sont choisis en fonction de la longueur d'onde utilisée pour le pompage optique et de la longueur d'onde d'émission souhaitée.

Dans le cas du néodyme un codopage cérium-chrome peut être envisagé.

En l'absence de terre rare autre que le lanthane, d'yttrium ou de scandium, le chrome joue le rôle d'activateur.

La substitution partielle de l'aluminium par du chrome et/ou la substitution partielle des atomes luminescents par du cérium, du dysprosium, du thulium, du samarium trivalents, ou de l'europium divalent, selon le type d'activateur, permet d'augmenter considérablement le rendement des lasers utilisant des monocristaux d'aluminates selon l'invention.

Etant donné que la durée de vie de l'état excité $E_1$ détroît lorsque la quantité en ions luminescent croît et qu'inversement l'intensité de fluorescence augmente lorsque la quantité en ions luminescents croît, les monocristaux pour lesquels x est faible, par exemple voisin de 0,1 pour le néodyme, sont plus particulièrement adaptés à la réalisation de lasers de puissance fonctionnant en continu alors que les monocristaux pour lesquels x est plus important, par exemple $0,2 \leqslant x \leqslant 0,5$ pour le néodyme, sont mieux adaptés à la fabrication de laser de puissance fonctionnant en impulsions.

D'autres caractéristiques et avantages de l'invention ressortiront mieux de la description qui va suivre, donnée à titre purement illustratif et nullement limitatif, en référence aux figures annexées dans lesquelles:

la figure 1 représente schématiquement un laser continu utilisant un monocristal d'aluminate selon l'invention, et

la figure 2 représente schématiquement un laser pulsé de puissance utilisant un monocristal d'aluminate selon l'invention.

On décrit ci-après la fabrication des aluminates mixtes de lanthanide-magnésium de l'invention répondant à la formule (I).

Ces aluminates sont obtenus en mélangeant intimement dans des proportions requises, les poudres du commerce de haute pureté des oxydes de lanthane, de Tr, de magnésium, d'aluminium et de chrome, puis en calcinat le mélange obtenu à une température de l'ordre de 1500°C. Aprés broyage du produit résultant, on obtient une poudre qui peut alors être traitée en vue de réaliser un monocristal.

Les poudres d'aluminates peuvent aussi être obtenues par coprécipitation à l'état amorphe des hydroxydes de lanthane, de Tr, de magnésium, d'aluminium, et de chrome. Cette coprécipitation est réalisée avec de l'ammoniac dans une solution aqueuse ou non telle que l'alcool absolu contenant un mélange de nitrate ou de chlorure des différents éléments métalliques de l'aluminate. Les nitrates ou chlorures de magnésium, d'aluminium et de chrome sont ceux du commerce tandis que les autres nitrates ou chlorures sont obtenus par dissolution de l'oxyde correspondant respectivement dans l'acide nitrique ou chlorhydrique.

Le mélange obtenu est ensuite traité à 400°C en atmosphère ventilée jusqu'à sa déshydratation et l'élimination completé du nitrate ou chlorure d'ammonium puis calciné à une température de 1500°C. La poudre obtenue, après broyage, peut alors être traitée en vue de réaliser un monocristal.

Les oxydes pulvérulents des différents éléments utilisés présentent une granulométrie allant de 1 à 10 micromètres et une pureté supérieure a 99,99% afin d'obtenir un rendement aussi élevé que possible pour l'émission laser.

De préférence, les monocristaux des aluminates selon l'invention sont élaborés par tirage Czochralski. Toutefois, toute autre méthode de cristallogénèse utilisant un bain fondu peut être utilisée comme par exemple la méthode de zone flottante, la méthode de Bridgmann, la méthode de Verneuil, la méthode de Kyropoulos, ou la méthode de l'auto-creuset, modifiée ou non.

A titre d'exemple, on décrit ci-aprés l'obtention d'un monocristal, d'un aluminate selon l'invention par

tirage Czochralski, technique bien connue de l'homme de l'art.

La poudre d'aluminate mixte, obtenue par coprécipitation ou mélange intime puis traitement thermique, comme décrit ci-dessus, est après broyage placée dans un creuset d'iridium puis portée à une température de fusion égale à 1810°C, à l'abri de l'air de manière à former un bain fondu.

Un germe monocristallin de même composition que le bain fondu et taillé parallèlement, soit à la direction cristallographique dite c, soit à la direction dite *a* de la maille hexagonale du composé, est alors amené au contact du bain liquide, puis remonté lentement vers le haut tout en étant animé d'un mouvement de rotation sur lui-même. Le monocristal est ainsi formé progressivement au bout du germe selon la direction imposée par celui-ci.

Ce procédé a permis de fabriquer un grand nombre de monocristaux d'aluminates selon l'invention, de grandes dimensions, présentant l'effet laser.

En particulier, il a permis la fabrication de monocristaux de formule

$$(a)\ La_{1-x}Tr_xMg_{1-t}Al_{11}O_{19-t}$$

dans laquelle Tr représente le praséodyme, l'holmium, l'erbium, le thulium, les couples cérium-néodyme, cérium-praséodyme, cérium-holmium, cérium-erbium, praséodyme-samarium, praséodyme-dysprosium, ou praséodyme-thulium.

Dans ces aluminates, correspondant à v = y = u = z = 0 dans la formule (I), le définit en magnésium est compensé par des lacunes d'oxygène.

Des exemples d'aluminates selon l'invention répondant à la formule (a) et réalisés sous forme de monocristaux sont donnés ci-après.

$$La_{0,95}Pr_{0,05}Mg_{0,75}Al_{11}O_{18,75}$$

$$La_{0,95}Ho_{0,05}Mg_{0,75}Al_{11}O_{18,75}$$

$$La_{0,95}Er_{0,05}Mg_{0,75}Al_{11}O_{18,75}$$

$$La_{0,95}Tm_{0,05}Mg_{0,75}Al_{11}O_{18,75}$$

$$La_{0,90}Ce_{0,005}Nd_{0,095}Mg_{0,5}Al_{11}O_{18,5}$$

$$La_{0,90}Ce_{0,005}Ho_{0,095}Mg_{0,75}Al_{11}O_{18,75}$$

$$La_{0,95}Ce_{0,0025}Er_{0,0475}Mg_{0,75}Al_{11}O_{18,75}$$

$$La_{0,80}Pr_{0,15}Sm_{0,05}Mg_{0,75}Al_{11}O_{18,75}$$

$$La_{0,90}Pr_{0,05}Sm_{0,05}Mg_{0,75}Al_{11}O_{18,75}$$

$$La_{0,90}Pr_{0,05}Dy_{0,05}Mg_{0,75}Al_{11}O_{18,75}$$

$$La_{0,83}Pr_{0,15}Dy_{0,02}Mg_{0,75}Al_{11}O_{18,75}$$

$$La_{0,73}Pr_{0,25}Tm_{0,02}Mg_{0,75}Al_{11}O_{18,75}$$

$$La_{0,90}Pr_{0,08}Tm_{0,02}Mg_{0,75}Al_{11}O_{18,75}$$

On a aussi réalisé sous forme de monocristaux, ayant des propriétés lasers, des aluminates selon l'invention répondant à la formule

$$(b)\ La_{1-x}Tr_xMg_{1-z}Al_{11+2z/3}O_{19}$$

dans laquelle Tr représente le praséodyme, les couples cérium néodyme, praséodyme-europium divalent, néodyme-europium divalent.

Dans ces aluminates, correspondant à y = v = t = u = 0 dans la formule (I), le déficit en magnésium est compensé par un excés d'aluminium. De même la conservation de la neutralité électrique lors de l'utilisation des couples $Pr^{3+}$—$Eu^{2+}$ ou $Nd^{3+}$—$Eu^{2+}$, est assurée par l'adjonction d'une quantité d'aluminium égale à 2/3 de [$Eu^{2+}$].

Comme exemples d'aluminates satisfaisant à la formule (b), réalisés sous forme monocristalline, on peut citer:

$$La_{0,95}Pr_{0,05}Mg_{0,5}Al_{11,333}O_{19}$$

$$La_{0,90}Ce_{0,005}Nd_{0,095}Mg_{0,5}Al_{11,333}O_{19}$$

$$La_{0,90}Pr_{0,095}Eu^{2+}_{0,005}Mg_{0,75}Al_{11,168}O_{19}$$

$$La_{0,90}Nd_{0,095}Eu^{2+}_{0,005}Mg_{0,75}Al_{11,168}O_{19}$$

On a aussi réalisé des monocristaux d'aluminates présentant l'effet laser et satisfaisant à la formule

$$(c)\ (La_{1-x}Tr_x)_{1-v}Mg_{1-t}Al_{11}O_{19-t-3v/2}$$

avec Tr représentant en particulier le néodyme.

Dans ces aluminates, correspondant dans la formule (I) à y = z = u = 0, le déficit en lanthanide et en magnésium est compensé par des lacunes d'oxygène.

Comme exemples d'aluminates présentant la formule (c), on peut citer les composés suivants:

$$(La_{0,90}Nd_{0,10})_{0,8}Mg_{0,75}Al_{11}O_{18,45}$$

$$(La_{0,90}Nd_{0,10})_{0,8}Mg_{0,8}Al_{11}O_{18,5}$$

Comme autres monocristaux présentant l'effet laser, il a été réalisé des aluminates satisfaisant à la formule

$$(d)\ (La_{1-x}Tr_x)_{1-y}Mg_{1-z}Al_{11+y+2z/3}O_{19}$$

dans laquelle Tr représente en particulier le néodyme ou le praséodyme. Dans le cas du néodyme x varie avantageusement de 0,1 à 0,5 (bornes comprises); y peut prendre toutes les valeurs de 0 à 0,4 et z est de préférence compris entre 0,45 et 1.

Dans ces aluminates, correspondant à v = t = u = 0 dans la formule (I), le déficit en lanthanide et en magnésium est compensé par un excès d'aluminium.

Comme exemples particuliers d'aluminates répondant à la formule (d), réalisés sous forme de monocristaux, on peut citer les composés suivants:

$$(La_{0,95}Pr_{0,05})_{0,9}Mg_{0,5}Al_{11,433}O_{19}$$

$$(La_{0,90}Nd_{0,10})_{0,7}Mg_{0,8}Al_{11,433}O_{19}$$

$$(La_{0,90}Nd_{0,10})_{0,9}Mg_{0,5}Al_{11,433}O_{19}$$

Le dernier composé présente une composition optimale. Il a pu être obtenu par la méthode de Czochralski à partir d'un bain présentant une composition trés proche de celle du monocristal. En effet, cet aluminate présente une fusion dite congruante. En outre, il est parfaitement bien adapté à la réalisation d'un laser de puissance continu émettant à 1054, 1082 ou 1320 nm.

D'autres monocristaux d'aluminates selon l'invention présentant l'effet laser et répondant à la formule

$$(e)\ (La_{1-x}Tr_x)_{1-v}MgAl_{11}O_{19-3v/2}$$

avec en particulier Tr représentant le néodyme, ont été fabriqués.

Dans ces aluminates, correspondant à y = z = t = u = 0 dans la formule (I), le déficit en lanthanide est compensé par la présence de lacunes d'oxygène.

Comme aluminates présentant la formule (e) on peut citer par exemple le composé

$$(La_{0,90}Nd_{0,10})_{0,9}MgAl_{11}O_{18,85}.$$

Comme autres monocristaux d'aluminate présentant l'effet laser, il a été fabriqué des composés répondant à la formule

$$(f)\ (La_{1-x}Tr_x)_{1-y}MgAl_{11+y}O_{19}$$

dans laquelle Tr représente en particulier le néodyme.

Dans ces composés, correspondant à v = z = t = u = 0 dans la formule (I), le déficit en lanthanide est compensé par un excès d'aluminium.

Comme aluminates répondant à la formule (f) on peut citer le composé

$$(La_{0,90}Nd_{0,10})_{0,85}MgAl_{11,15}O_{19}.$$

On a aussi réalisé des monocristaux ayant des propriétés lasers représentant la formule

$$(g)\ La_{1-x}Tr_xMgAl_{11}O_{19}$$

dans laquelle Tr représente le couple praséodyme-europium divalent ou le couple néodyme-europium divalent avec conservation de la neutralité électrique par l'adjonction de lacunes d'oxygène égales à $1/2[Eu^{2+}]$.

Comme aluminates répondant à la formule (g) ci-dessus on peut citer par exemples les composés:

$$La_{0,95}Pr_{0,095}Eu^{2+}_{0,005}MgAl_{11}O_{18,9975}\ \text{et}$$

$$La_{0,90}Nd_{0,095}Eu^{2+}_{0,005}MgAl_{11}O_{18,9975}$$

Dans tous les aluminates répondant aux formules a, b, c, d, e, f ou g, ci-dessus et contenant du néodyme il est possible de substituer une partie de l'aluminium par du chrome afin d'augmenter le rendement de l'effet laser des aluminates correspondants.

De méme dans les aluminates répondant aux formules a, c, d, e ou f, ci-dessus, il est possible de substituier une partie de l'activateur laser (Pr, Nd) par $Eu^{2+}$ en conservant la neutralité électrique par l'adjonction d'aluminium ou de lacune d'oxygène.

Comme aluminates contenant du chrome en tant que sensibilisateur laser répondant à la formule (I), on peut citer par exemple:

$$(La_{0,90}Ce_{0,005}Nd_{0,095})_{0,9}Mg_{0,5}Al_{11,383}Cr_{0,05}O_{19}\ \text{et}$$

$$(La_{0,90}Nd_{0,10})_{0,9}Mg_{0,5}Al_{11,383}Cr_{0,05}O_{19}$$

Ce dernier composé présente un composition optimale étant donné qu'il présente une fusion dite congruante. Ce matériau peut être réalisé sous forme de monocristaux de grandes dimensions par la méthode de Czochralski et être utilisé avantageusement comme émetteur laser dans une laser continu de puissance émettant à 1054, 1083 ou 1320 nm.

Par ailleurs, il a été réalisé des monocristaux d'aluminate selon l'invention ne contenant comme lanthanides que du lanthane, l'effet laser étant alors dû au chrome présent dans l'aluminate.

Comme exemple d'aluminates ne contenant que du lanthane comme lanthanide on peut citer l'aluminate de formule:

$$La_{0,9}Mg_{0,5}Al_{11,383}Cr_{0,05}O_{19}.$$

Ce composé a l'avantage de présenter une fusion dite congruante et donc de pouvoir être réalisé sous forme de monocristaux de grandes dimensions.

L'emission laser de cet aluminate étant dû au chrome, ce composé peut être utilisé comme émetteur laser émettant dans le visible entre 680 et 800 nm. Etant donné la large bande d'émission du chrome, un tel composé peut être avantageusement utilisé dans un laser de puissance accordable en longueur d'onde, fonctionnement en continu ou en impulsions.

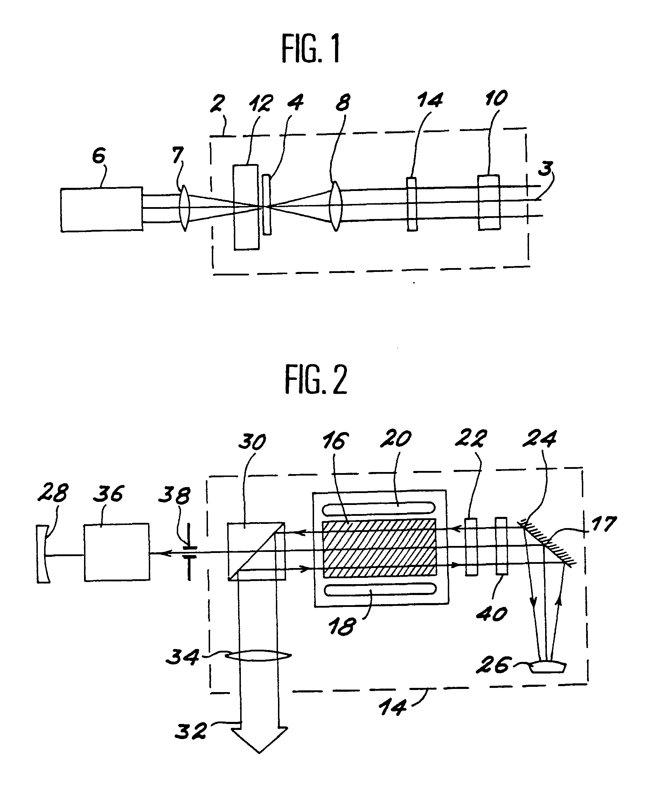

Sur la figure 1, on a représenté schématiquement un laser de puissance continu utilisant un monocristal d'aluminate selon l'invention.

Ce laser comprend une cavité laser 2 contenant un barreau 4 d'aluminate selon l'invention disposé perpendiculairement à l'axe longitudinal 3 du laser. Ce barreau d'aluminate 4 présente par exemple la formule

$$(La_{0,90}Nd_{0,10})_{0,9}Mg_{0,5}Al_{11,433}O_{19}$$

ou la formule

$$(La_{0,90}Nd_{0,10})_{0,9}Mg_{0,5}Al_{11,383}Cr_{0,05}O_{19}$$

émettant dans l'infrarouge.

Une source de lumière monochromatique 6, telle qu'un laser à argon ou krypton ionisé, permet d'irradier le barreau d'aluminate 4, via une lentille de convergence 7, afin d'assurer le pompage optique du barreau 4.

La cavité laser 2 se compose aussi d'une lentille convergente 8 transformant la lumière émise par le barreau d'aluminate 4 en un faisceau de lumière parallèle qui est envoyé sur un miroir de sortie 10.

Après réflexion sur ce miroir 10, le faisceau lumineux transverse à nouveau la lentille convergente 8 et le milieu amplificateur ou barreau d'aluminate 4. Le faisceau laser amplifié est alors réfléchi par un miroir d'entrée dichroïque 12 à proximite duquel est placé le barreau 4, ce miroir 12 étant transparent à la lumière émise par la source monochromatique 6 et opaque à celle émise par le monocristal d'aluminate 4.

Le faisceau laser suffisamment amplifié, dans la cavité 2 est alors envoyé vers l'extérieur du laser, via le miroir 10, qui est partiellement transparent à la lumière émise par le monocristal d'aluminate 4.

Le remplacement du barreau 4 d'aluminate de néodyme-magnésium par un aluminate selon l'invention de praséodyme-magnésium, par exemple de formule:

$$(La_{0,95}Pr_{0,05})_{0,9}Mg_{0,5}Al_{11,433}O_{19}$$

conduit à un laser de puissance continu émettant dans le visible et en particulier dans le jaune et le rouge.

De la même façon, on peut utiliser un barreau d'aluminate contenant à la place du néodyme de l'holmium, de l'erbium, du thulium, combinés ou non avec le cérium afin d'obtenir des lasers de puissance émettant dans une grande gamme de longueur d'onde.

En particulier, l'utilisation d'un aluminate contenant de l'holmium permet l'émission d'un faisceau laser dont la longueur d'onde varie de 1,5 à 3 micromètres suivant la transition choisie.

En outre, il est possible d'utiliser un barreau d'aluminate ne contenant comme lanthanide que du lanthane, présentant par exemple la formule

$$La_{0,9}Mg_{0,5}Al_{11,383}Cr_{0,05}O_{19},$$

en vue d'obtenir un laser de puissance continu, accordable en longueur d'onde dans une gamme allant de 680 à 800 nm.

L'accordabilité en longueur d'onde peut être obtenue à l'aide d'une système de sélection en longueur d'onde 14 intercalé entre la lentille convergente 8 et le miroir de sortie 10 de la cavité laser 2, du type prisme à angle de Brewster ou filtre interférentiel formé de deux lames en matériau biréfringent.

Les aluminates selon l'invention peuvent aussi être utilisés sous forme monocristalline dans un laser de puissance émettant sous forme d'impulsions. A cet effet, on a représenté sur la figure 2, un laser de puissance pulsé, émettant dans l'infrarouge.

Ce laser pulsé comprend une cavité 14 contenant un barreau monocristallin 16 d'un aluminate selon

l'invention disposé parallèlement à l'axe longitudinal 17 du laser. Cet aluminate présente par exemple la formule:

$$La_{1-x}Nd_xMg_{1-z}Al_{11+2z/3}O_{19} \text{ avec } 0,2\leq x\leq 0,5 \text{ et } 0\leq z<0,55.$$

De part et d'autre du barreau 16, sont disposées des lampes flash au xénon de forte intensité 18 et 20, de forme allongée, orientées aussi selon l'axe 17 du laser. Ces lampes assurent un pompage optique longitudinal du barreau d'aluminate 16.

La cavité laser 14 se compose aussi d'une lame quart d'onde 22 transformant la lumière incidente polarisée linéairement, issue du barreau 16, en une lumière polarisée circulairement. Cette lame 22 est suivie d'un miroir plan 24 et d'un miroir convexe 26 divergent.

Après réflexion sur le miroir 26, le faisceau lumineux élargi, adapté et polarisé circulairement, traverse à nouveau la lame quart d'onde 22 produisant ainsi en faisceau polarisé verticalement qui balaye complètement le milieu amplificateur ou barreau 16, en en extrayant le maximum d'énergie lumineuse.

Le faisceau laser amplifié se propageant dans la direction d'un autre miroir 28 hautement réfléchissant concave, est interrompu par un prisme polariseur 30 éjectant le faisceau polarisé verticalement 32 hors de la cavité laser. Une lentille convergente 34 permet l'obtention d'un faisceau de lumière parallèle.

Ce laser pulsé est équipé d'un interrupteur électro-optique 36, plus généralement désigné sous le vocable anglo-saxon de "$Q_1$ switch", disposé entre le miroir concave 38 et le polariseur de sortie 30. Lorsque cet interrupteur est fermé, c'est-à-dire qu'une tension lui est appliquée, le laser ne peut fonctionner. En effet, pendant que l'on "pompe", le milieu amplificateur avec les lampes 18 et 20, le polariseur 30 est transparent aux photons polarisés horizontalement et laisse passer la lumière vers l'interrupteur 36. Celui-ci faisant tourner la direction de polarisation de 90° empêhe le polariseur 30 de transmettre cette lumière.

Inversement, lorsqu'on ouvre l'interrupteur électro-optique 36, celui-ci n'altère plus la polarisation horizontale issue du polariseur permettant ainsi à la cavité laser 14 d'amplifier la lumière émise par le barreau 16.

Un diaphragme 38 peut être intecalé entre l'interrupteur et le polariseur pour canaliser la lumière laser.

Comme précédemment, le barreau 16 à base de néodyme peut être remplacé par un barreau à base de praséodyme, d'holmium, d'erbium, de thulium, combiné avec du cerium, répondant aux formules ci-dessus en vue d'obtenir d'autres lasers de puissance pulsé. Il convient simplement d'adaptor le revêtement des miroirs 26 et 28 à la longueur d'onde d'émission laser recherchée.

Pour obtenir un laser accordable en longueur d'onde, par exemple en utilisant un aluminate selon l'invention contenant du chrome comme activateur laser, un dispositif de sélection en longueur d'onde 40 tels que décrits ci-dessus doit être intercalé entre la lame 22 et le miroir 24.

Les lasers décrits ci-dessus n'ont bien entendu été donnés qu'à titre illustratif, d'autres types de lasers pouvant être équipés d'un monocristal d'un aluminate selon l'invention répondant à la formule (I).

Les monocristaux des aluminates selon l'invention dans lequel Tr représente le néodyme peuvent être utilisés dans toutes les applications utilisant actuellement un émetteur laser du type YAG. En particulier, ces monocristaux peuvent être utilisés pour des lasers destinés à la découpe ou au marquage de matériau ainsi que pour réaliser des soudures.

La découpe de matériau est assurée par exemple en plaçant un aluminate monocristallin activé au néodyme dans la cavité d'un laser, tel que décrit précédemment, en orientant puis en focalisant à la surface du matériau la lumière issue du laser afin de porter ce matériau localement à son point de fusion et d'assurer ainsi sa découpe au fur et à mesure qu'il se déplace dans le faisceau laser.

En plus, des applications du type YAG, les aluminates selon l'invention contenant du néodyme présentent des applications qui leur sont propres.

En particulier un monocristal à base de néodyme selon l'invention peut être placé dans la cavité d'un laser munie d'un filtre sélectif permettant d'accorder la longueur d'onde de la lumière émise autour de 1,082 micromètres. Cette lumière peut alors être utilisée pour polariser les atomes d'un gaz (de l'hélium III ou IV par exemple).

Dans le domaine de la fusion thermonucléaire, cette polarisation de l'hélium III ou IV peut être utilisée pour augmenter considérablement la probabilité de la réaction de fusion des $D—^3H_e$.

Un monocristal d'un aluminate à base de néodyme selon l'invention, à sa longueur d'onde normale d'émission de 1,054 micrométres, peut avantageusement être utilisé comme oscillateur dans une chaîne laser à barreau de verres phosphate ou fluorophosphate activé au néodyme pour déclencher la réaction de fusion thermonucléaire.

Dans le domaine de l'accélération de particules, la polarisation des atomes d'un gaz tel que l'hélium peut être utilisée pour réaliser des faisceaux d'ions polarisés, employés dans les accélérateurs de particules.

Dans le domaine de la magnétométrie et de la gyrométrie, l'utilisation d'un laser de puissance contenant un aluminate monocristallin à base de néodyme selon l'invention permet d'améliorer les performances des magnétomètres ou gyroscopes à pompage optique existants notamment en ce qui concerne leur consommation, leur durée de vie et leur maniabilité. Dans ce cas particulier, les émetteurs lasers selon l'invention peuvent également déboucher sur le développement de nouveaux dispositifs magnétométriques ou gyroscopiques.

On donne ci-après une application particulière de l'aluminate selon l'invention activé au chrome.

Un monocristal de cet aluminate est placé dans une cavité laser comportant un élément dispersif (tel qu'un prisme ou un réseau) permettant d'accorder continûment la longueur d'onde entre 680 et 800 nm. Ce dispositif peut être utilisé dans la détection de certains éléments de l'atmosphère terrestre. Pour cela, la longueur d'onde doit être choisie de manière à ce quélle corresponde à la d'absorption de l'espèce à détecter. L'affaiblissement de l'écho laser envoyé par un obstacle est fonction de la quantité et de la nature de l'espèce contenue dans l'atmosphère. Ceci peut être utilisé par exemple pour la météorologie à distance.

## Revendications

1. Aluminate mixte de lanthanide-magnésium, caractérisé en ce que l'aluminate présente la formule suivante:

$$(La_{1-x}Tr_{x})_{1-y-v}Mg_{1-z-t}Al_{11-u+y+2z/3}Cr_{u}O_{19-t-3v/2}$$

dans laquelle Tr représente a) au moins un corps simple trivalent choisi parmi les lanthanides autres que le lanthane, excepté lorsque u est ≠ 0, l'yttrium et le scandium, ou b) au moins un couple de lanthanides formé d'un élément bivalent et d'un élément trivalent autre que le lanthane, excepté lorsque u est ≠ 0, avec conservation de la neutralité électrique par adjonction d'aluminium ou de lacunes d'oxygène, ou toute combinaison de ce(s) corps simple(s) et de ce(s) couple(s); x représente un nombre tel que 0 ≤ × 1; y et v représentent des nombres tels que $0 \leq y + v \leq 0{,}4$; z et t représentent des nombres tels $0 \leq z + t < 1$ à condition que lorsque $z + t = 0$, $y + v$ soit $\neq 0$ pour Tr représentant un seul lanthanide trivalent; u représente un nombre allant de 0 à 2 à condition que lorsque Tr représente $Y^{3+}$ ou $Sc^{3+}$, u soit $\neq 0$, que lorsque $x = 0$, u soit $\neq 0$, que lorsque $u = 0$, x soit $\neq 0$ et que lorsque $y = v = z = u = 0$ et $t \neq 0$, Tr ne représente pas un seul lanthanide trivalent et que lorsque Tr = $Nd^{3+}$, $y - u + 2z/3$ soit $\neq 0$; et en ce que l'aluminate est monophasé et présente la structure de la magnétoplombite.

2. Aluminate mixte selon la revendication 1, caractérisé en ce que x est ≠ 0 et Tr est choisi parmi le néodyme, le praséodyme, l'erbium, l'holmium, le thulium, les couples néodyme-europium divalent, praséodyme-europium divalent et les couples cérium-néodyme, cérium-praséodyme, praséodyme-samarium, praséodyme-disprosium, praséodyme-thulium, cérium-erbium, cérium-holmium.

3. Aluminate mixte selon la revendication 1, caractérisé en ce que x = 0.

4. Aluminate mixte selon la revendication 1 ou 2, caractérisé en ce que Tr représente le néodyme, et x va de 0,2 à 0,5.

5. Aluminate mixte selon la revendication 1 ou 2, caractérisé en ce que Tr représente le néodyme, et x est voisin de 0,1.

6. Aluminate mixte selon l'une quelconque des revendications 1, 2 et 5, caractérisé en ce qu'il présente la formule suivante:

$$(La_{0,90}Nd_{0,10})_{0,9}Mg_{0,5}Al_{11,433}O_{19}.$$

7. Aluminate mixte selon l'une quelconque des revendications 1, 2 et 5, caractérisé en ce qu'il présente la formule suivante:

$$(La_{0,90}Nd_{0,10})_{0,9}Mg_{0,5}Al_{11,383}Cr_{0,05}O_{19}.$$

8. Aluminate mixte selon la revendication 1 ou 2, caractérisé en ce qu'il présente la formule suivante:

$$(La_{0,90}Ce_{0,005}Nd_{0,095})_{0,9}Mg_{0,5}Al_{11,383}Cr_{0,05}O_{19}.$$

9. Aluminate mixte selon l'une quelconque des revendications 1 à 3, caractérisé en ce qu'il présente la formule suivante:

$$La_{0,9}Mg_{0,5}Al_{11,383}Cr_{0,05}O_{19}.$$

10. Laser émettant dans l'infrarouge, caractérisé en ce qu'il comprend un monocristal d'un aluminate mixte selon l'une quelconque des revendications 2, 4, 7, 8 dans lequel Tr représente au moins en partie le néodyme, l'holmium ou l'erbium.

11. Laser accordable entre 680 et 800 nm, caractérisé en ce qu'il comprend un monocristal d'un aluminate mixte selon la revendication 3 ou 9.

12. Laser émettant dans le visible, caractérisé en ce qu'il comprend un monocristal d'un aluminate mixte selon la revendication 1 ou 2, dans lequel Tr représente au moins en partie le praséodyme.

**Patentansprüche**

1. Lanthaniden-Magnesium-Mischaluminat, dadurch gekennzeichnet, daß das Aluminat die folgende Formel hat:

$$(La_{1-x}Tr_{x})_{1-y-v}Mg_{1-z-t}Al_{11-u+y+2z/3}Cr_{u}O_{19-t-3v/2}$$

worin bedeuten:

Tr (a) mindestens einen einfachen trivalenten Vertreter, ausgewählt aus den Lanthaniden, die von Lanthan verschieden sind, ausgenommen Yttrium und Scandium, wenn $u \neq 0$, oder

(b) mindestens ein Lanthaniden-Paar aus einem bivalenten Element und einem trivalenten Element, das von Lanthan verschieden ist, ausgenommen wenn $u \neq 0$, unter Aufrechterhaltung der elektrischen Neutralität durch Zufügung von Aluminium oder Sauerstoff-Lücken oder jede Kombination dieser einfachen Vertreter und dieser Paare;

x eine solche Zahl, daß $0 \leq x < 1$;

y und v solche Zahlen, daß $0 \leq y + v \leq 0{,}4$;

z und t solche Zahlen, daß $0 \leq z + t < 1$, mit der Maßgabe, daß dann wenn $z + t = 0$, $y + v \neq 0$, falls Tr ein enzelnes trivalentes Lanthanidenelement darstellt;

u eine Zahl von 0 bis 2 mit der Maßgabe, daß dann, wenn Tr $Y^{3+}$ oder $Sc^{3+}$ darstellt, $u \neq 0$, daß dann, wenn $x = 0$, $u \neq 0$, daß dann, wenn $u = 0$, $x \neq 0$ und daß dann, wenn $y = v = z = u = 0$ und $t \neq 0$, Tr ein einzelnes trivalentes Lanthanidenelement darstellt und daß dann, wenn Tr = $Nd^{3+}$, $y - u + 2z/3 \neq 0$; und daß das Aluminat einphasig ist und die Struktur des Magnetoplombids hat.

2. Mischaluminat nach Anspruch 1, dadurch gekennzeichnet, daß $x \neq 0$ und Tr ausgewählt wird aus Neodym, Praseodym, Erbium, Holmium, Thulium, den Paaren Neodym-divalentes Europium, Praseodymdevalentes Europium und den Paaren Cer-Neodym, Cer-Praseodym, Praseodym-Samarium, Preseodym-Dysprosium, Praseodym-Thulium, Cer-Erbium, Cer-Holmium.

3. Mischaluminat nach Anspruch 1, dadurch gekennzeichnet, daß $x = 0$.

4. Mischaluminat nach Anspruch 1 oder 2, dadurch gekennzeichnet, daß Tr Neodym und x eine Zahl von 0,2 bis 0,5 darstellen.

5. Mischaluminat nach Anspruch 1 oder 2, dadurch gekennzeichnet, daß Tr Neodym und x eine Zahl in der Nähe von 0,1 darstellen.

6. Mischaluminat nach einem der Ansprüche 1, 2 und 5, dadurch gekennzeichnet, daß es die folgende Formel hat:

$$(La_{0,90}Nd_{0,10})_{0,9}Mg_{0,5}Al_{11,433}O_{19}.$$

7. Mischaluminat nach einem der Ansprüche 1, 2 und 5, dadurch gekennzeichnet, daß es die folgende Formel hat:

$$(La_{0,90}Nd_{0,10})_{0,9}Mg_{0,5}Al_{11,383}Cr_{0,05}O_{19}.$$

8. Mischaluminat nach den Ansprüchen 1 und 2, dadurch gekennzeichnet, daß es die folgende Formel hat:

$$(La_{0,90}Ce_{0,005}Nd_{0,095})_{0,9}Mg_{0,5}Al_{11,383}Cr_{0,05}O_{19}.$$

9. Mischaluminat nach einem der Ansprüche 1 bis 3, dadurch gekennzeichnet, daß es die folgende Formel hat:

$$La_{0,9}Mg_{0,5}Al_{11,383}Cr_{0,05}O_{19}.$$

10. Laser, der infrarotes Licht emittiert, dadurch gekennzeichnet, daß er umfaßt einen Einkristall aus einem Mischaluminat nach einem der Ansprüche 2, 4, 7 und 8, worin Tr mindestens zum Teil Neodym, Holmium oder Erbium darstellt.

11. Laser, der auf die Emission von Licht zwischen 680 und 800 nm einstellbar ist, dadurch gekennzeichnet, daß er umfaßt einen Einkristall aus einem Mischaluminat nach Anspruch 3 oder 9.

12. Laser, der sichtbares Licht emittiert, dadurch gekennzeichnet, daß er umfaßt einen Einkristall aus einem Mischaluminat nach Anspruch 1 oder 2, worin Tr mindestens zum Teil Praseodym darstellt.

**Claims**

1. Mixed lanthanide-magnesium aluminate, characterized in that the aluminate is of the following formula:

$$(La_{1-x}Tr_{x})_{1-y-v}Mg_{1-z-t}Al_{11-u+y+2z/3}Cr_{u}O_{19-t-3v/2}$$

in which Tr represents a) at least one single trivalent substance chosen from among lanthanides other than lanthanum, except when $u \neq 0$, yttrium and scandium, or b) at least one pair of lanthanides formed from a divalent element and a trivalent element other than lanthanum, except when $u \neq 0$, with retention of the electrical neutrality by adding aluminium or oxygen vacancies, or any combination of said single substance or substances and said pair or pairs; x represents a number such that $0 \leq x < 1$; y and v represent numbers such as $0 \leq y + v \leq 0.4$; z and t represent numbers such that $0 \leq z + t < 1$, provided that when $z + t = 0$, $y + v$ is $\neq 0$ for Tr representing a single trivalent lanthanide; u represents a number from 0 to 2, provided that when Tr represents $y^{3+}$ or $Sc^{3+}$ us is $\neq 0$, that when $x = 0$ u is $\neq 0$, that when $u = 0$ x is $\neq 0$ and that when $y = v = z = u = 0$ and $t \neq 0$ Tr does not represent a single trivalent lanthanide and that when $Tr = Nd^{3+}$, $y - u + 2z/3$ is $\neq 0$; and that the aluminate is single phase and has the structure of magnetoplumbite.

2. Mixed aluminate according to claim 1, characterized in that x is $\neq 0$ and Tr is chosen from among neodymium, praseodymium, erbium, holmium, thulium, divalent europium-neodymium pairs, divalent europium-praseodymium pairs and the pairs cerium-neodymium, cerium-praseodymium, praseodymium-samarium, praseodymium-dysprosium, praseodymium-thulium, cerium-erbium and cerium-holmium.

3. Mixed aluminate according to claim 1, characterized in that $x = 0$.

4. Mixed aluminate according to claims 1 or 2, characterized in that Tr represents neodymium and x is between 0.2 and 0.5.

5. Mixed aluminate according to claims 1 or 2, characterized in that Tr represents neodymium and x is about 0.1.

6. Mixed aluminate according to any one of the claims 1, 2 and 5, characterized in that it is of formula:

$$(La_{0.90}Nd_{0.10})_{0.9}Mg_{0.5}Al_{11.433}O_{19}.$$

7. Mixed aluminate according to any one of the claims 1, 2 and 5, characterized in that it is of formula:

$$(La_{0.90}Nd_{0.10})_{0.9}Mg_{0.5}Al_{11.383}Cr_{0.05}O_{19}.$$

8. Mixed aluminate according to claims 1 or 2, characterized in that it is of formula:

$$(La_{0.90}Ce_{0.005}Nd_{0.095})_{0.9}Mg_{0.5}Al_{11.383}Cr_{0.05}O_{19}.$$

9. Mixed aluminate according to any one of claims 1 to 3, characterized in that it is of formula:

$$La_{0.9}Mg_{0.5}Al_{11.383}Cr_{0.05}O_{19}.$$

10. Laser emitting in the infrared, characterized in that it comprises a monocrystal of a mixed aluminate according to any one of the claims 2, 4, 7, 8, wherein Tr represents at least partly neodymium, holmium or erbium.

11. Laser tunable at between 680 and 800 nm, characterized in that it comprises a monocrystal of a mixed aluminate according to claims 3 or 9.

12. Laser emitting in the visible range, characterized in that it comprises a monocrystal of a mixed aluminate according to claims 1 or 2, wherein Tr at least partly represents praseodymium.

FIG. 1

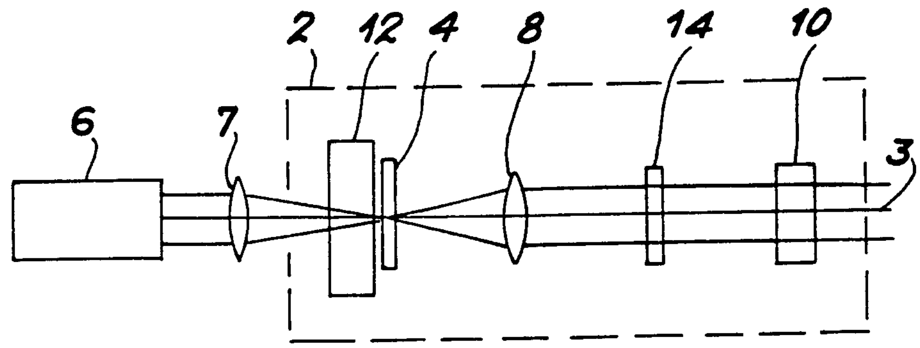


FIG. 2